# EUROPEAN PATENT APPLICATION

(11) **EP 2 980 681 A1**
(43) Date of publication of application: **03.02.2016**
(21) Application number: 14774417.1
(22) Date of filing: 25.03.2014
(51) Int. Cl.: G06F 3/041, G06F 3/044, H01B 5/14, H01B 13/00

(54) **METHOD FOR PRODUCING TRANSPARENT CONDUCTIVE SUBSTRATE, AND TRANSPARENT CONDUCTIVE SUBSTRATE**

(30) Priority: 29.03.2013 JP 2013071844
(71) Applicant: Showa Denko K.K., Tokyo 105-8518 (JP)
(72) Inventor: UCHIDA Hiroshi, Tokyo 105-8518 (JP)
(74) Representative: Strehl Schübel-Hopf & Partner
(86) International application number: PCT/JP2014/058336
(87) International publication number: WO 2014/157234

(57) **Abstract**

Provided are a transparent conductive substrate production method and a transparent conductive substrate, which can be produced by simple steps, has superior pattern recognition performance, and is suitable for an electrostatic capacitance touch panel. Using a transparent conductive ink, first electrode regions 12 and second electrode regions 14 are printed on different positions on the same plane, a first electrode connecting region 16 which electrically connects the first electrode regions 12 is printed, and then, subjected to pulsed light irradiation, to form a sintered conductive body. Thereafter, the surface of the first electrode connecting region 16 is covered with a transparent insulation layer 18. Using the transparent conductive ink, a second electrode connecting region 20 which passes on the surface of the transparent insulation layer 18 and electrically connects the second electrode regions 14 in a direction different from the connecting direction of the first electrode connecting region 16 is printed, and then, subjected to pulsed light irradiation, to form a sintered conductive body.

## Description

### Technical Field

The present disclosure relates to a transparent conductive substrate production method and a transparent conductive substrate.

### Background Art

As various electronic devices such as mobile phones, mobile terminals, personal computers, or the like, have become highly functional and diversified, recently used is an electronic device which has an optically transparent touch panel attached on the front face of its display panel. A person can switch the functions of such an electronic device by pressing the surface of the touch panel with his/her finger, a pen, etc., while viewing the display on the display panel on the back side through the touch panel.

As for such a touch panel, for example, an electrostatic capacitance touch panel is known, which has a transparent substrate on which a predetermined shaped transparent electrode pattern is formed in the X-direction, and similar transparent electrode pattern is formed in the Y-direction (the direction perpendicular to the X-direction).

Such an electrostatic capacitance touch panel is used, for example, by being arranged on the display surface of a display unit of an electronic device, and has a substrate made of a transparent material on which a transparent electrode pattern is formed.

Patent Document 1 discloses that, in order to prevent difficulties in visual understanding of a display, a car navigation system, etc., the X and Y electrode patterns are respectively formed by laminated films in which a silicon oxidized film is provided between a pair of upper and lower ITO films, and are provided with a light transmission property.

Patent Document 2 discloses that a plurality of transparent capacitance sensing nodes, each functioning to be independent from each other and representing a different point on a touch panel, are formed by a group of spatially separated lines, using a transparent conductive material,. The group of spatially separated lines includes a driving line and a sensing line, the sensing line being electrically insulated from the driving line and arranged to be perpendicular to the driving line, to form a capacitance sensing node, the driving line being connected to a voltage source, and the sensing line being connected to a device which limits the parasitic capacitance.

In order to form a transparent electrode pattern as above, for a conventional transparent conductive film made of a metal oxide material such as ITO, a method for subjecting the transparent conductive film formed on the substrate by a vacuum process to wet etching, is commonly used (refer to Patent Documents 3 to 5). Further, recently, a transparent conductive film using nanowires has been proposed, and in this case, the conductive pattern is also formed by a wet etching method, and the productivity is inferior (refer to Patent Document 6).

Therefore, it has been desired to directly forming a pattern by printing an ink composition containing silver nanoparticles into a mesh form, or by subjecting an ink composition containing silver nanowires to inkjet printing, screen printing, gravure printing, flexo printing, and the like. However, in order to perform printing, a binder resin is necessary, and in order to maintain the transparent property, the amount of silver nanoparticles or silver nanowires to be used should be smaller. Accordingly, there are drawbacks that the binder resin used therein covers the surfaces of the silver nanoparticles or silver nanowires, and in the case of the silver nanowires, the conductivity may be lost. When the binder resin is not used, there are drawbacks that the pattern cannot be kept during printing, or even if the pattern can be kept immediately after the printing, the pattern may be collapsed when the solvent contained in the ink composition is dried.

### Prior Arts

### Patent Document

Patent Document 1: Japanese Unexamined Patent Publication (Kokai) No. 2008-310550
Patent Document 2: Japanese Unexamined Patent Publication (Kokai) No. 2011-81825
Patent Document 3: Japanese Unexamined Patent Publication (Kokai) No. 2000-67762
Patent Document 4: Japanese Unexamined Patent Publication (Kokai) No. 2003-57673
Patent Document 5: Japanese Unexamined Patent Publication (Kokai) No. 2001-42344
Patent Document 6: Japanese Unexamined Patent Publication (Kohyo) No. 2009-505358

### Summary

One of the objectives of the present disclosure is to provide a preferable transparent conductive substrate production method for an electrostatic capacitance touch panel having a high pattern recognition property, by simple steps without using a vacuum process and a wet etching method, and to provide a transparent conductive substrate.

In order to achieve the above objectives, one aspect of the present disclosure is a method for producing a transparent conductive substrate comprising a substrate provided on one main face thereof with a first electrode pattern comprising a plurality of first electrode regions, the adjacent first electrode regions being electrically connected with each other, and a second electrode pattern comprising a plurality of second electrode regions, the adjacent second electrode regions being electrically connected with each other, and the first electrode pattern being electrically separated from the second electrode pattern, the method comprising a step of printing the first and second electrode regions into a predetermined pattern shape, with a transparent conductive ink containing metal nanowires or metal fine particles, and a step for sintering the metal nanowires or the metal fine particles contained in the transparent conductive ink, by subjecting the first and second electrode region printed in the predetermined pattern shape to pulsed light irradiation.

Further, another aspect of the present disclosure is a method for producing a transparent conductive substrate comprising: an electrode region printing step for printing a plurality of first electrode regions and a plurality of second electrode regions with a transparent conductive ink containing metal nanowires or metal fine particles, on the same plane, at different positions, a first electrode connecting region printing step for printing a first electrode connecting region which electrically connects adjacent first electrode regions with the transparent conductive ink in one direction, a first sintering step for sintering the metal nanowires or metal fine particles by subjecting the first electrode regions, the second electrode regions and the first electrode connecting region to pulsed light irradiation, a first electrode connecting region covering step for covering a surface of the first electrode connecting region with a transparent insulation layer, after the first sintering step, a second electrode connecting region printing step for printing a second electrode connecting region which passes on the surface of the transparent insulation layer and electrically connects adjacent second electrode regions in a direction different from the connecting direction of the first electrode connecting region, with the transparent conductive ink, and a second sintering step for sintering the metal nanowires or metal fine particles by subjecting the second electrode connecting region to pulsed light irradiation.

Here, the first electrode connecting region is preferably formed to be perpendicular to the second electrode connecting region.

A method for producing a transparent conductive substrate further comprising, after the second sintering step, a lead-out electrode printing step for printing first lead-out electrode to be electrically connected to the first electrode region, and a second lead-out electrode to be electrically connected to the second electrode region, with the transparent conductive ink containing metal fine particles as a metal component, and a lead-out electrode sintering step for sintering the metal fine particles by subjecting the first lead-out electrode and the second lead-out electrode to pulsed light irradiation.

A method for producing a transparent conductive substrate, wherein the transparent conductive ink is a transparent conductive ink containing metal fine particles as a metal component; in the electrode region printing step, the transparent conductive ink is used for forming the first electrode regions and the second electrode regions in a mesh form by lattices of thin lines, and for printing the first lead-out electrode to be electrically connected to the first electrode region, and the second lead-out electrode to be electrically connected to the second electrode region; and in the first sintering step, the first lead-out electrode and the second lead-out electrode are also subjected to the pulsed light irradiation to sinter the metal fine particles.

Forming an overcoat layer on the substrate is preferable, the substrate being already provided thereon with the first electrode regions, the second electrode regions, the first electrode connecting regions, the transparent insulation layers, the second electrode connecting regions, the first lead-out electrode, and the second lead-out electrode.

Further, a still another aspect of the present disclosure is a method for producing a transparent conductive substrate comprising: first electrode pattern printing step for printing a first electrode pattern with a transparent conductive ink containing metal nanowires or metal fine particles, the first electrode pattern comprising a plurality of first electrode region, and a first electrode region which electrically connects the adjacent first electrode regions in one direction, a first electrode pattern sintering step for sintering the metal nanowires or the metal fine particles by subjecting the first electrode pattern to pulsed light irradiation, a transparent insulation layer forming step for forming a transparent insulation layer on the first electrode pattern, the transparent insulation layer covering the entirety of the first electrode connecting regions and having an area smaller than the part where the first electrode pattern is formed, a second electrode pattern printing step for printing a second electrode pattern on the transparent insulation layer, with the transparent conductive ink, the second electrode pattern comprising a plurality of second electrode regions located at positions different from the plurality of first electrode regions on the plane of projection, and second electrode connecting regions electrically connecting the adjacent second electrode regions in the direction different from the connecting direction of the first electrode connecting regions, and a second electrode pattern sintering step for sintering the metal nanowires or the metal fine particles by subjecting the second electrode pattern to pulsed light irradiation.

Here, the first electrode connecting region is preferably formed to be perpendicular to the second electrode connecting region.

A method for producing a transparent conductive substrate, further comprising, after the second electrode pattern sintering step, a lead-out electrode printing step for printing first lead-out electrode to be electrically connected to the first electrode region, and a second lead-out electrode to be electrically connected to the second electrode region, with the transparent conductive ink containing metal fine particles as a metal component, and a lead-out electrode sintering step for sintering the metal fine particles by subjecting the first lead-out electrode and the second lead-out electrode to pulsed light irradiation.

A method for producing a transparent conductive substrate, wherein: the transparent conductive ink is a transparent conductive ink containing metal fine particles as a metal component; in the first electrode pattern printing step, the transparent conductive ink being used for forming the first electrode regions in a mesh form by lattices of thin lines, and for printing the first lead-out electrode to be electrically connected to the first electrode region; in the first sintering step, the first lead-out electrode is also subjected to the pulsed light irradiation; in the second electrode pattern printing step, the transparent conductive ink is used for forming the second electrode regions in a mesh form by lattices of thin lines, and for printing the second lead-out electrode to be electrically connected to the second electrode region, and in the second sintering step, the second lead-out electrode is also subjected to the pulsed light irradiation.

Forming an overcoat layer on the substrate is preferable, the substrate being already provided thereon with the first electrode regions, the first electrode connecting regions, the transparent insulation layer, the second electrode regions, the second electrode connecting regions, the first lead-out electrode, and the second lead-out electrode.

Further, a still another aspect of the present disclosure is a transparent conductive substrate comprising a substrate provided on one main face thereof with, a first electrode pattern comprising first electrode regions and a first electrode connecting region electrically connecting the first electrode regions, and formed by sintered metal, and a second electrode pattern comprising second electrode regions and a second electrode connecting region electrically connecting the second electrode regions, and formed by sintered metal, the first electrode regions and the second electrode regions being arranged on different positions on the same plane, and the first electrode connecting region and the second electrode connecting region being nonparallel and spatially separated from each other.

Here, the surface of the first electrode connecting region is covered with a transparent insulation layer having substantially the same shape as the first electrode connecting region, and the second electrode connecting region passes on the surface of the transparent insulation layer.

Further, a still another aspect of the present disclosure A transparent conductive substrate comprising a substrate provided on one main face thereof with, a first electrode pattern comprising first electrode regions and a first electrode connecting region electrically connecting the first electrode regions, and formed by sintered metal, a second electrode pattern comprising second electrode regions located at positions different from the first electrode regions on the plane of projection, and a second electrode connecting region electrically connecting the second electrode regions, and formed by sintered metal, and a transparent insulation layer located between the first electrode pattern and the second electrode pattern, the transparent insulation layer covering the entirety of the first electrode connecting regions and having an area smaller than the part where the first electrode pattern is formed, first electrode pattern and the second electrode pattern being arranged in directions intersecting with each other.

According to the present disclosure, a transparent conductive substrate suitable for an electrostatic capacitance touch panel having a high pattern recognition property can be produced, by simple steps without using a vacuum process and a wet etching method.

### BRIEF DESCRIPTION OF DRAWINGS

FIG. 1 is a plan view illustrating an example of a transparent conductive substrate, for explaining production steps of a transparent conductive substrate for an electrostatic capacitance touch panel according to the first aspect of the disclosure.
FIG. 2 is a plan view illustrating an example of a transparent conductive substrate, for explaining production steps of a transparent conductive substrate for an electrostatic capacitance touch panel according to the first aspect of the disclosure.
FIG. 3 is a plan view illustrating an example of a transparent conductive substrate, for explaining production steps of a transparent conductive substrate for an electrostatic capacitance touch panel according to the first aspect of the disclosure.
FIG. 4 is a plan view illustrating an example of a transparent conductive substrate, for explaining production steps of a transparent conductive substrate for an electrostatic capacitance touch panel according to the first aspect of the disclosure.
FIG. 5 is a plan view illustrating an example of a transparent conductive substrate, for explaining production steps of a transparent conductive substrate for an electrostatic capacitance touch panel according to the first aspect of the disclosure.
FIG. 6 is a view for explaining a mesh pattern using metal fine particles.
FIG. 7 is a view illustrating the definition of pulsed light.
FIG. 8 is a plan view illustrating an example of a transparent conductive substrate, for explaining production steps of a transparent conductive substrate for an electrostatic capacitance touch panel according to the second aspect of the disclosure.
FIG. 9 is a plan view illustrating an example of a transparent conductive substrate, for explaining production steps of a transparent conductive substrate for an electrostatic capacitance touch panel according to the second aspect of the disclosure.
FIG. 10 is a plan view illustrating an example of a transparent conductive substrate, for explaining production steps of a transparent conductive substrate for an electrostatic capacitance touch panel according to the second aspect of the disclosure.
FIG. 11 is a plan view illustrating an example of a transparent conductive substrate, for explaining production steps of a transparent conductive substrate for an electrostatic capacitance touch panel according to the second aspect of the disclosure.

### Embodiment

Hereinbelow, an exemplary embodiment of the present invention (hereinafter, referred to as an embodiment) will be described, with reference to the drawings. In the present specification, "transparent" of the transparent conductive substrate means the light transmittance of 65% or more within the visible light range (400 to 800 nm).

The present embodiment discloses a method for producing a transparent conductive substrate comprising a substrate provided on one main face thereof with a first electrode pattern comprising a plurality of first electrode regions, the adjacent first electrode regions being electrically connected with each other, and a second electrode pattern comprising a plurality of second electrode regions, the adjacent second electrode regions being electrically connected with each other, and the first electrode pattern being electrically separated from the second electrode pattern, the method comprising a step of printing the first and second electrode regions into a predetermined pattern shape, with a transparent conductive ink containing metal nanowires or metal fine particles, and a step for sintering the metal nanowires or the metal fine particles contained in the transparent conductive ink, by subjecting the first and second electrode region printed in the predetermined pattern shape to pulsed light irradiation. Hereinbelow, the first and second aspects of the disclosure will be explained.

### (First Aspect of Disclosure)

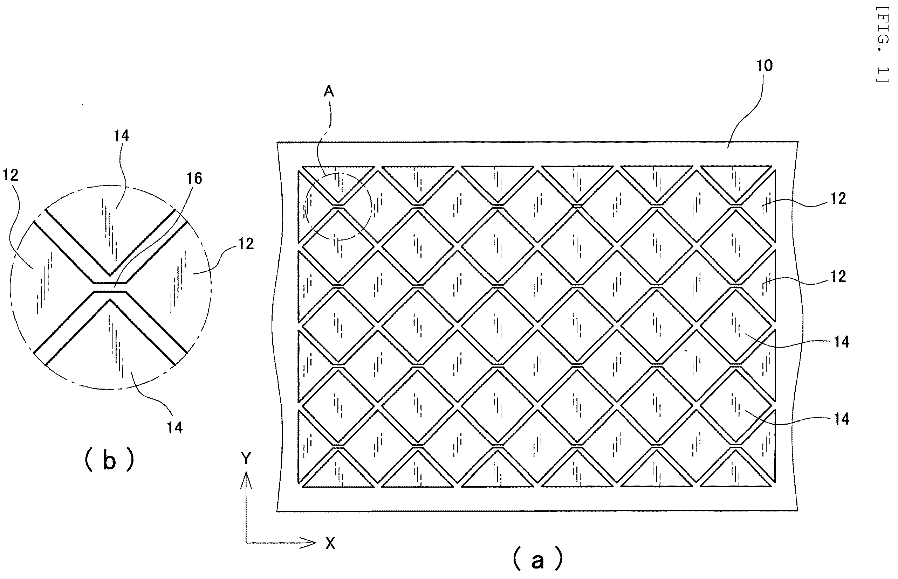

FIG. 1 to FIG. 5 show plan views of an example of a transparent conductive substrate for explaining production steps of a transparent conductive substrate for an electrostatic capacitance touch panel according to the first aspect of the disclosure. In the drawings, same numeral is assigned to the same structural component. In FIG. 1 (a), a plurality of first electrode regions 12 and a plurality of second electrode regions 14 are printed on one main face of a substrate 10, with a transparent conductive ink containing metal nanowires or metal fine particles, by a printing method such as inkjet printing, screen printing, gravure printing, flexo printing, and the like (Electrode Region Printing Step). The first electrode regions 12 and the second electrode regions 14 are printed on different positions in the main face (same plane) of the substrate 10. Here, the different positions mean that the electrode regions do not overlap in the same plane. This does not only means that the first electrode region 12 does not overlap the second electrode region 14, but also means that a plurality of linearly arranged first electrode regions 12 do not overlap with each other, and the second electrode regions 14 do not overlap with each other. The first electrode region 12 and the second electrode region 14 may be formed with the same transparent conductive ink, but may be formed with different transparent conductive ink. In case of the latter, for example, a transparent conductive ink containing metal nanowires as a metal component may be used for forming the first electrode region, whereas a transparent conductive ink containing metal fine particles as a metal component for forming the second electrode region, and vice versa.

According to the present aspect of the disclosure, the first electrode region 12 and the second electrode region 14 are formed as rhombus regions. Thereby, the electrode regions do not overlap with each other, and the first electrode regions 12 and the second electrode regions 14 can be formed on the main face of the substrate 10 at a high density. However, the shape of the electrode region is not limited to rhombus, and can be any shape as far as the electrode regions can be printed without overlapping with each other.

Further, according to the example of FIG. 1(a), a first electrode connecting region 16 which connects the adjacent first electrode regions 12 electrically and in one direction, is printed with the transparent conductive ink (First Electrode Connecting Region Printing Step). This step may be performed at the same time as the step for printing the first electrode regions 12. FIG. 1 (b) shows an enlarged view showing an encircled portion indicated as A in FIG. 1(a), in which the first electrode connecting region 16, as well as the first electrode regions 12 and the second electrode regions 14 therearound are shown. In FIG. 1(b), the first electrode connecting region 16 connects opposing vertexes of the two first electrode regions 12 in the lateral direction in the drawing (the X-direction in FIG. 1(a)).

The first electrode regions 12, the second electrode regions 14, and the first electrode connecting regions 16 mentioned above are subjected to heating with an oven, heating by photo irradiation using a far-infrared lamp, and the like, to be dried and/or cured. Thereafter, the first electrode regions 12, the second electrode regions 14, and the first electrode connecting regions 16 are irradiated with pulsed light to sinter the metal nanowires or the metal fine particles (First Sintering Step). Thereby, the first electrode regions 12, the second electrode regions 14, and the first electrode connecting regions 16 are provided with conductivity.

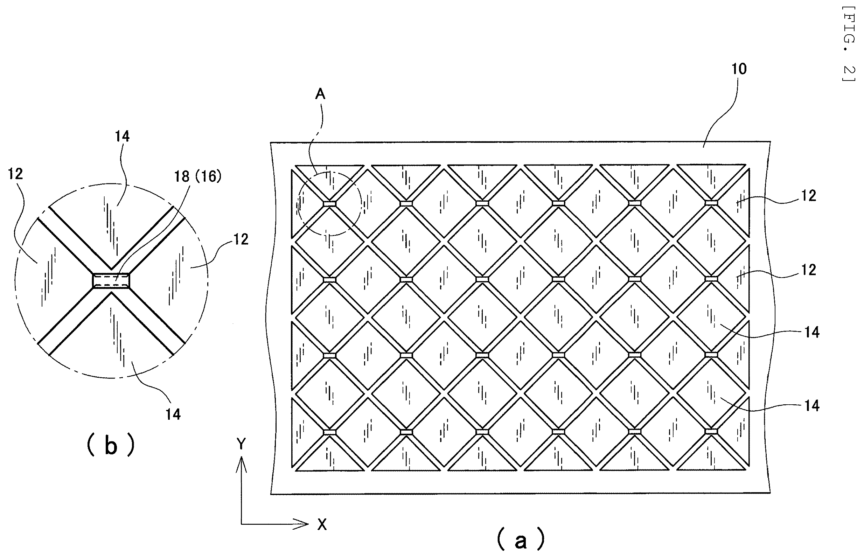

Next, as shown in FIG. 2(a) and FIG. 2(b) which is an enlarged view of an encircled portion indicated as A in FIG. 2 (a), after the first sintering step, the surface of the first electrode connecting region 16 is covered with a transparent insulation layer 18 (First Electrode Connecting Region Covering Step). The transparent insulation layer 18 must cover the entire surface of the first electrode connecting region 16, but the transparent insulation layer 18 does not cover the entirety of the first electrode region 12 and the second electrode region 14. This is because a lead-out electrode which is to be printed thereafter, should be connected to at least one end of the first electrode region 12 and at least one end of the second electrode region 14, and the adjacent second electrode regions 14 should be connected with each other. The areas of the transparent insulation layer 18 overlapping the first electrode region 12 and the second electrode region 14 are preferably 1/4 or less, more preferably 1/8 or less of the first and second electrode regions 12 and 14, respectively.

In FIG. 2 (a) and FIG. 2 (b), the first electrode connecting region 16 is covered with the transparent insulation layer 18 having substantially the same shape as the first electrode connecting region 16 (the first electrode connecting region 16 is covered until its ends (the side substantially parallel with the major axis, and thus, in the plan view, the first electrode connecting region 16 does not appear. In FIG. 2(b), the expression 18 (16) indicates that the first electrode connecting region 16 is present below the transparent insulation layer 18.

The transparent insulation layer 18 is formed through pattern printing by screen printing, gravure printing, gravure offset printing, inkjet printing, etc., using an ink of a thermoplastic resin dissolved in a solvent, an ink of a liquid curable resin, or an ink of a curable resin dissolved in a solvent, and drying the solvent when the solvent is used, and curing when the curable resin is used. As for the curable resin, both a thermosetting resin and a photocurable resin can be used.

When an ink of a thermoplastic resin dissolved in a solvent is used for the transparent insulation layer 18 which covers the first electrode connecting region 16, the ink is subjected to heating with an oven or heating by photo irradiation using a far-infrared lamp, to be dried. When an ink of a liquid curable resin is used, the ink is cured. When an ink of a curable resin dissolved in a solvent is used, the ink is dried and cured. The curing may be performed by heating with an oven, photocuring by ultraviolet ray irradiation, and the like, depending on the type of the resin.

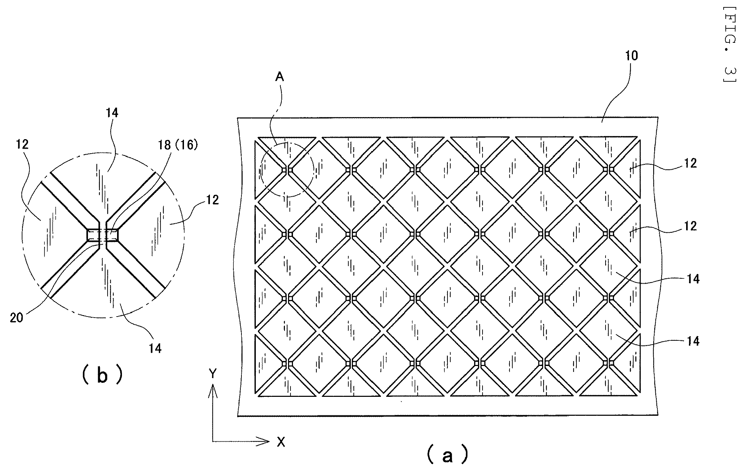

Next, as shown in FIG. 3(a) and FIG. 3(b) which is an enlarged view of an encircled portion indicated as A in FIG. 3(a), a second electrode connecting region 20 is printed with the transparent conducive ink so as to pass on the surface of the dried transparent insulation layer 18 and electrically connect the second electrode regions 14 in a direction different from the first electrode connecting region 16 (Second Electrode Connecting Region Printing Step). In FIG. 3(b), the second electrode connecting region 20 connects opposing vertexes of the two second electrode regions 14 in the vertical direction in the drawing (the Y-direction in FIG. 3(a)), and the second electrode connecting region 20 and the first electrode connecting region 16 are nonparallel and spatially separated from each other.

In the example shown in FIG. 3 (a) and FIG. 3 (b), the first electrode connecting region 16 is perpendicular to the second electrode connecting region 20 (X-direction and the Y-direction), but the present disclosure is not limited thereto, and the angle therebetween may be appropriate determined depending on the shape of the first electrode region 12 and the second electrode region 14, etc.

The second electrode connecting regions 20 are subjected to heating with an oven, heating by photo irradiation using a far-infrared lamp, and the like, to be dried and/or cured. Thereafter, the second electrode connecting regions 20 are irradiated with pulsed light to sinter the metal nanowires or the metal fine particles (Second Sintering Step). Thereby, the second electrode connecting regions 20 are provided with conductivity.

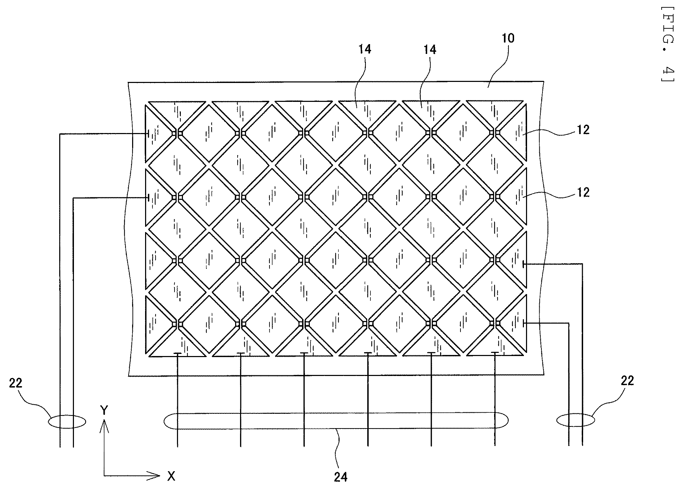

As shown in FIG. 4, one electrode region located at the end of each array of the first electrode regions 12 and one electrode region located at the end of each array of the second electrode regions 14 are respectively connected to the first lead-out electrode 22 and the second lead-out electrode 24. The first and second lead-out electrodes 22 and 24 are formed with a transparent conductive ink containing metal fine particles as a metal component. The first and second lead-out electrodes 22 and 24 should have a narrower width and a lower resistance than the first and second electrode regions 12 and 14, and thus, using a transparent conductive ink containing metal fine particles as a metal component is preferable.

After the above second sintering step, the first lead-out electrode 22 electrically connected to the first electrode region 12 located at an end of the above array, and the second lead-out electrode 24 electrically connected to the second electrode region 14 located at an end of the above array, are printed with the transparent conductive ink containing metal fine particles as a metal component (Lead-Out Electrode Printing Step).

The first lead-out electrode 22 and the second lead-out electrode 24 that have been printed, are then, subjected to heating with an oven, heating by photo irradiation using a far-infrared lamp, and the like, to be dried and/or cured. Thereafter, the first lead-out electrode 22 and the second lead-out electrode 24 are irradiated with pulsed light to sinter the metal fine particles (Lead-Out Electrode Sintering Step). Thereby, the first lead-out electrode 22 and the second lead-out electrode 24 are provided with conductivity.

When a transparent conductive ink containing metal fine particles as a metal component is used for forming the first and second electrode regions 12 and 14, the first and second electrode regions 12 and 14 can be formed with the transparent conductive ink same as the ink for forming the first and second lead-out electrodes 22 and 24. Therefore, in the above electrode region printing step, the first lead-out electrode 22 electrically connected to the first electrode region 12 located at the end of the array and the second lead-out electrode 24 electrically connected to the second electrode region 14 located at the end of the array can be printed at the same time, and then, dried and/or cured. Subsequently, in the first sintering step, the first lead-out electrode 22 and the second lead-out electrode 24 are irradiated with pulsed light to sinter the metal fine particles. Thereby, the first lead-out electrode 22 and the second lead-out electrode 24 are provided with conductivity.

The first lead-out electrode 22 and the second lead-out electrode 24 mentioned above are formed on the same main face (same plane) of the substrate 10, and thus, production steps can be simplified and the production cost can be reduced, compared to the case where electrodes are respectively provided on the front and rear surfaces of the substrate and connected through a through hole formed on the substrate to make the lead-out electrodes be on the same plane.

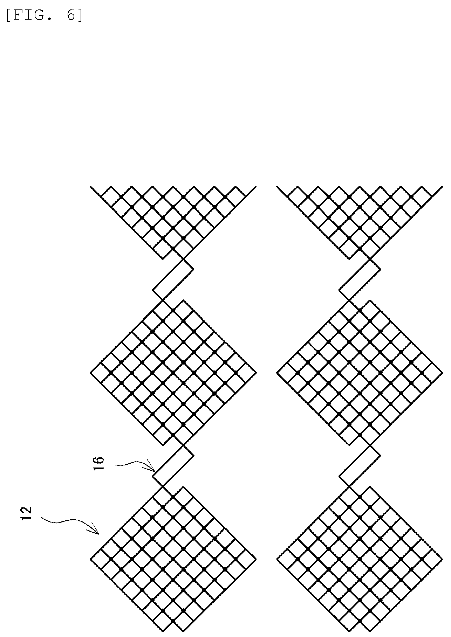

When a transparent conductive ink containing metal fine particles as a metal component is used, the first electrode region 12, the second electrode region 14, the first electrode connecting region 16, and the second electrode connecting region 20 are preferably structured into a mesh formed by a lattice made of thin lines, as shown in FIG. 6. Accordingly, the light transmittance at a portion where the first electrode region 12, the second electrode region 14, the first electrode connecting region 16, and the second electrode connecting region 20 are formed, can be increased, and the transparency at the portion can be obtained.

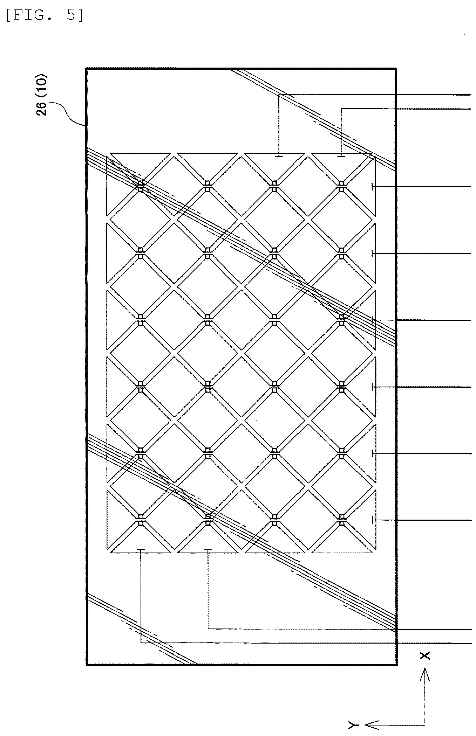

Next, as shown in FIG. 5, after the above-mentioned first electrode region 12, second electrode region 14, first electrode connecting region 16, transparent insulation layer 18, second electrode connecting region 20, first lead-out electrode 22, and second lead-out electrode 24 are formed on the substrate 10, an overcoat layer 26 is further formed on the substrate 10. In FIG. 5, the expression 26(10) indicates that substrate 10 is present below the overcoat layer 26. The overcoat layer 26 is formed through pattern printing by screen printing, gravure printing, gravure offset printing, inkjet printing, etc., using an ink of a thermoplastic resin dissolved in a solvent, an ink of a liquid curable resin, or an ink of a curable resin dissolved in a solvent, and drying the solvent when the solvent is used, and curing when the curable resin is used. As for the curable resin, both a thermosetting resin and a photocurable resin can be used.

The transparent conductive ink may be an ink in which metal nanowires or metal fine particles are dispersed in a dispersion medium containing a shape-holding material mentioned below. The above shape-holding material contains an organic compound having a molecular weight in the range from 150 to 500, and having a viscosity of 1.0×10³ to 2.0×10⁶ mPa·s at 25°C. Here, if the organic compound having the viscosity of the above range at 25°C is liquid, the shape-holding material may be composed only by the organic compound. On the other hand, if the viscosity of the organic compound at 25°C is higher than the above viscosity range, or the organic compound is solid at 25°C, the organic compound may be previously mixed (diluted, dissolved) with an appropriate solvent (a solvent capable of dissolving the organic compound, such as below-mentioned viscosity adjustment solvent, etc.) to prepare a liquid shape-holding material having a viscosity of the above mentioned range.

If the shape-holding material has a viscosity lower than the above range, the shape of the printed pattern cannot be maintained, whereas if the shape-holding material has a viscosity higher than the above range, bad influences such as occurrence of thread-forming may be caused at the time of printing. More preferably, the shape-holding material has a viscosity in the range of 5.0×10⁴ to 1.0×10⁶ mPa·s at 25°C.

If the organic compound contained in the shape-holding material to be used has a too large molecular weight, the shape-holding material cannot be efficiently removed at the time of sintering, and thus, the resistance cannot be decreased. Therefore, the molecular weight is 500 or lower, preferably 400 or lower, more preferably 300 or lower.

The organic compound contained in the shape-holding material is preferably a compound containing a hydroxyl group, and for example, monosaccharides, polyol, or a compound having a quaternary carbon atom, and/or an alkyl group comprising a bridged carbon cyclic structure and a hydroxyl group, is preferable. For example, diglycerine, 2,2,4-trimethyl-1,3-pentanediolmonoisobutyrate, 2,2,4-trimethyl-1,3-pentanediol diisobutyrate, xylulose, ribulose, bornylcyclohexanol, bornylphenol, isobornylcyclohexanol, isobornylphenol, etc., may be exemplified.

Among the above listed compounds, a compound having an isobornyl group and a hydroxyl group is particularly preferable. Not only the complicated steric structure of the isobornyl group, but also the hydrogen bond of the hydroxyl group, apply an appropriate viscosity to the ink. Further, a compound having an isobornyl group and a hydroxyl group has a high viscosity although the volatilization temperature is not very high, resulting in providing a transparent conductive ink having a high viscosity. As a compound having an isobornyl group and a hydroxyl group, either one or both of isobornyl cyclohexanol or isobornylphenol may be exemplified. The above listed compounds have an appropriate viscosity, and may apply an appropriate viscosity to the transparent conductive ink. Further, because the compound has an appropriate boiling point as an ink solvent, the residual may be reduced during appropriate heating, photosintering, after the completion of printing and drying. The content of the shape-holding material in the ink is preferably 10 to 95% by mass relative to the total mass of the dispersion medium, and is more preferably 30 to 80% by mass. If the content of the shape-holding material is less than 10% by mass, the transparent conductive ink cannot have an appropriate viscosity, and printing cannot be performed. If the content of the shape-holding material exceeds 95% by mass, the viscosity of the transparent conductive ink is too high, causing worse thread-forming property at the time of printing, and printing may not be performed.

It is desired that the shape-holding material itself is a viscous liquid having a viscosity in the above range. However, other viscosity adjustment solvent may be mixed to satisfy the above viscosity range, and to prepare a dispersion medium having a viscosity in the above range, and thereby, the transparent conductive ink may be provided by dispersing metal nanowires and/or metal fine particles as conductive components in the dispersion medium.

The viscosity adjustment solvent may be, for example, water, alcohol, ketone, ester, ether, hydrocarbon solvents, and aromatic solvents. In order that each component in the ink composition can be well dispersed, a preferable viscosity adjustment solvent may be water, ethanol, isopropyl alcohol, 1-methoxy-2-propanol (PGME), ethylene glycol, diethylene glycol, triethylene glycol, dipropylene glycol, ethylene glycol monomethyl ether, ethylene glycol monoethyl ether, ethylene glycol monopropyl ether, diacetone alcohol, ethylene glycol monobutyl ether, propylene glycol, diethylene glycol monomethyl ether, diethylene glycol monoethyl ether, dipropylene glycol monopropyl ether, diethylene glycol monobutyl ether, tripropylene glycol, triethylene glycol monoethyl ether, terpineol, dihydroterpineol, dihydroterpinyl monoacetate, methyl ethyl ketone, cyclohexanone, ethyl lactate, propylene glycol monomethyl ether acetate, diethylene glycol monomethyl ether acetate, diethylene glycol monobutyl ether acetate, ethylene glycol monomethyl ether acetate, ethylene glycol monobutyl ether acetate, dibutyl ether, octane, or toluene, and among them, terpineol is particularly preferable. Each solvent may be used by itself, but two or more kinds of the solvents may be mixed.

Further, a binder resin may be used as the dispersion medium. The binder resin may be a thermoplastic resin or a thermoset resin, which is, for example, a poly-N-vinyl compound such as poly-N-vinylpyrrolidone (PVP), poly-N-vinyl caprolactam, and poly-N-vinylacetamide, a polyalkylene glycol compound such as polyethyleneglycol, polypropyleneglycol, and poly THF, polyurethane, a cellulose compound and a derivative thereof, an epoxy compound, a polyester compound, chlorinated polyolefin, and a polyacrylic compound. Also, both the shape-holding material and the binder resin can be used together.

The metal nanowire is a metal having a diameter of the wire in the order of nanometer, and is a conductive material having a wire shape (including a hollow tube shape). The metal fine particle is a metal having a diameter (outer diameter) in the order of micrometer or nanometer, and is a conductive material having a granular shape. Both of them may be soft or rigid. The metal nanowires and the metal fine particles may contain a metal oxide in at least a part thereof.

The kind of the metal may be one selected from the group consisting of gold, silver, platinum, copper, nickel, iron, cobalt, zinc, ruthenium, rhodium, palladium, cadmium, osmium, and iridium, or an alloy etc. , formed by combining some of these. In order to obtain a coating film having a low surface resistance and a high total light transmittance, containing at least one of gold, silver, and copper is preferable. These metals have a high conductivity, and thus, when a certain surface resistance should be obtained, the density of the metal within the surface may be reduced, and high total light transmittance can be achieved.

Among these metals, containing at least gold or silver is preferable. The most appropriate example may be silver.

The metal nanowires in the transparent conductive ink preferably show certain distributions regarding their diameter sizes, major axis lengths, and aspect ratios. The distributions are selected so that the coating film obtained by the transparent conductive ink according to the present aspect of the disclosure has a high total light transmittance and a low surface resistance. Specifically, the metal nanowires have an average diameter size of preferably 1 nm or more and 500 nm or less, more preferably 5 nm or more and 200 nm less, still more preferably 5 nm of more and 100 nm or less, and particularly preferably 10 nm or more and 100 nm or less. The average major axis length of the metal nanowires is preferably 1 µm or more and 100 µm or less, more preferably 1 µm or more and 50 µm or less, still more preferably 2 µm or more and 50 µm or less, and particularly preferably 5 µm or more and 30 µm or less. While satisfying the above average diameter size and the average major axis length, the metal nanowires have an average aspect ratio of preferably 2 or more, more preferably 10 or more, still more preferably 100 or more, and particularly preferably 200 or more. Here, the aspect ratio refers to a value obtained by a/b, wherein "b" represents an average diameter size of the metal nanowires and "a" represents an average major axis length thereof. The values "a" and "b" may be measured by a scanning electron microscope. By controlling the concentration of the metal nanowires in the transparent conductive ink and maintaining the conductivity by the inter-locking of the wires, the transparent conductive film can be formed.

The content of the metal nanowires in the transparent conductive ink containing metal nanowires is 0.01 to 10% by mass, and more preferably 0.05 to 2% by mass, relative to the total mass of the transparent conductive ink, from the viewpoints of preferable dispersion property of the metal nanowires, preferable pattern forming property of the coating film obtained by the transparent conductive ink, high conductivity, and a preferable optical property. If the content of the metal nanowires is less than 0.01% by mass, a very thick transparent conductive film layer should be printed in order to ensure a desired conductivity, and thus, the degree of difficulty in printing increases, and maintaining the pattern during drying becomes difficult. If the content of the nanowires exceeds 10% by mass, the printing must be performed very thin in order to ensure a desired transparency, and the printing is also difficult. When the metal nanowires are used, the content must be smaller compared to the case where the below-mentioned metal fine particles are used, in order to maintain the transparency.

When metal fine particles are used, spherical particles are preferable. When the metal fine particles are used, particles should be in contact to each other in order to obtain the conductivity. Accordingly, the concentration of the metal fine particles in the transparent conductive ink must be made high, and thus, if the ink is printed over the surface, i.e., over the entirety of the electrode region as shown in FIG. 1, etc., the transparency cannot be obtained. Therefore, when the metal fine particles are used, the first electrode regions 12 and the first electrode connecting regions 16 are printed in a mesh formed by thin lines, as shown in FIG. 6, to maintain transparency. The same is true for the second electrode regions 14 and the second electrode connecting regions 20

In this case, the line width of the mesh is preferably 10 µm or less, and the space between the lines should be at least 3 times, and preferably 10 times of the line width. In order to print a mesh having a small line width, the diameter of the metal fine particles is at least 3 µm or less, preferably 1 µm or less, and more preferably 500 nm or less. Here, the particle diameter refers to a median diameter (D50) which is obtained by measuring diameters using a particle diameter distribution measurement device by a dynamic light scattering method, specifically, Nanotrac UPA-150 (a dynamic light scattering method) manufactured by Nikkiso Co., Ltd, and performing spherical approximation.

The content of metal fine particles in the transparent conductive ink containing metal fine particles is 50 to 85% by mass, and more preferably 60 to 80% by mass, relative to the total mass of the transparent conductive ink. Compared to the above-mentioned case where the metal nanowires are used, the content of the metal fine particles is high, and a low resistance film can be obtained. Therefore, even if the electrode pattern is printed in a thin mesh form, the obtained properties are substantially the same as the case where the transparent conductive ink containing metal nanowires is printed over the entirety.

The transparent conductive ink may contain other components such as a reducing agent, etc., in accordance with needs. When a metal which can be easily oxidized, such as copper, etc., or a metal oxide is used for the nanowire/nanoparticle material, mixing a reducing agent is preferable. The reducing agent which can be used, may be an alcohol compound, such as methanol, ethanol, isopropyl alcohol, butanol, cyclohexanol, and terpineol; polyhydric alcohol, such as ethylene glycol, propylene glycol, and glycerin; a carboxylic acid, such as formic acid, acetic acid, oxalic acid, and succinic acid; a carbonyl compound, such as acetone, methyl ethyl ketone, benzaldehyde, and octyl aldehyde; an ester compound, such as ethyl acetate, butyl acetate, and phenyl acetate; and a hydrocarbon compound, such as hexane, cyclohexane, octane, toluene, naphthalene, and decalin. Among those mentioned above, polyhydric alcohol, such as ethyleneglycol, propyleneglycol, glycerin and the like, and carboxylic acid, such as formic acid, acetic acid, and oxalic acid are preferable in view of the efficiency of a reducing agent. Polyethyleneglycol and polypropyleneglycol which are classified as polyhydric alcohol are preferable because they can also function as a binder resin.

The substrate 10 may be rigid or easily bent, and may be colored, but is preferably has high light transmittance and a low haze value. Therefore, the material for the substrate 10 maybe, for example, inorganic glass, polyimide, polycarbonate, polyether sulfone, acrylic resin, polyarylate, polyethylene terephthalate, polyethylene naphthalate, chain polyolefin such as polypropylene or poly-4-methyl-pentene-1, cyclic polyolefin (cycloolefin copolymer (COC), cycloolefin polymer (COP)), polyvinyl chloride, or the like. A polyester film such as polyethylene terephthalate, polyethylene naphthalate, a polycarbonate film, an acryloyl film such as polymethyl methacrylate, a transparent polyimide film using an alicyclic material, inorganic glass, may be more preferable. In particular, since the roll-to-roll processing is performed, the use of a polyester film is preferable.

With respect to the thickness of the substrate 10, if the thickness is too small, there may be drawbacks regarding the strength at the coating step and the size stability during drying, whereas if the thickness is too large, performing the roll-to-roll step becomes difficult. Therefore, the thickness is preferably 12 µm to 500 µm, and more preferably, 25 µm to 188 µm. In order to improve the adhesive property of the surface, an easy adhesion treatment may be performed, and as far as the transparency is maintained, a corona treatment or a plasma treatment may be performed.

The material for the transparent insulation layer 18 and the overcoat layer 26 should be a resin having a high light transmittance. Accordingly, the material therefor may be cyclic polyolefin (cycloolefin copolymer (COC), cycloolefin polymer (COP)), polycarbonate, epoxy resin (phenoxy type), polyvinyl butylal, ethylene-vinylacetate copolymer, ethylene vinylalcohol copolymer, acrylic resin, allyl ester resin, epoxy acrylate resin, urethane acrylate, and the like.

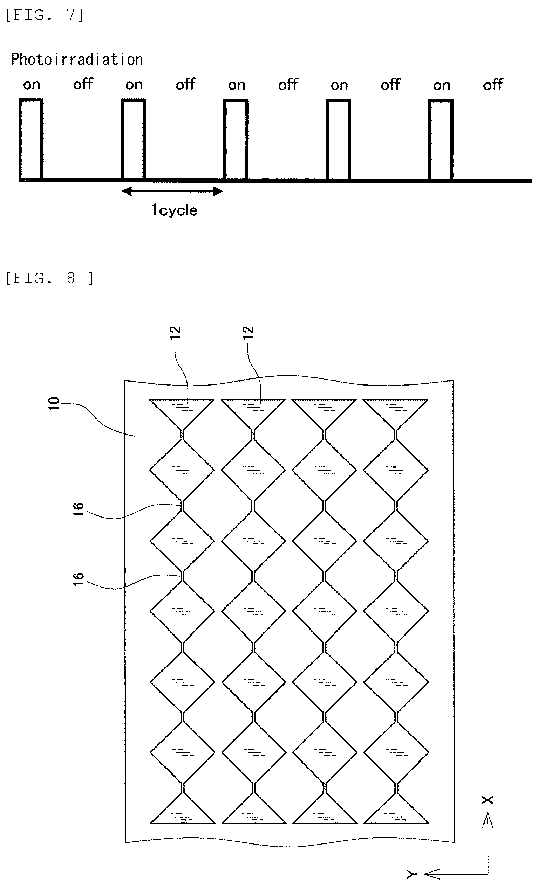

As mentioned above, pulsed light is used at the first sintering step, the second sintering step, the lead-out electrode sintering step, etc. In the present specification, the "pulsed light" is a light having a short photoirradiation period (irradiation time). When a plurality of times of photoirradiation are repeated, as shown in FIG. 7, there is a period in which photoirradiation is not performed (irradiation interval (off)) between a first photoirradiation period (on) and a second photoirradiation period (on). In FIG. 7, the pulsed light is illustrated to have a constant light intensity, but the light intensity may vary within one photoirradiation period (on). The pulsed light is irradiated from a light source provided with a flash lamp such as a xenon flash lamp. Using such a light source, pulsed light is irradiated to metal nanowires or metal fine particles in the first electrode region 12, the second electrode region 14, the first electrode connecting region 16, the second electrode connecting region 20, the first lead-out electrode 22, and the second lead-out electrode 24. When irradiation is repeated for n-times, one cycle (on + off) in FIG. 7 is repeated for n-times. At the time of repeated irradiation, it is preferable to cool the substrate 10 from the back side so that the substrate material can be cooled to a temperature near the room temperature when the next pulsed light irradiation is performed.

For the pulsed light, electromagnetic waves having a wavelength in the range from 1 pm to 1 m may be used, preferably, electromagnetic waves having a wavelength in the range from 10 nm to 1000 µm may be used (from far ultraviolet to far infrared), and more preferably, electromagnetic waves having a wavelength in the range from 100 nm to 2000 nm may be used. Examples of such electromagnetic wave may be gamma rays, X-rays, ultraviolet rays, visible rays, infrared rays, microwaves, radiowaves on the longer wavelength side of the microwaves, and the like. Considering transformation into thermal energy, too short wavelength is not preferable because the substrate 10, the first electrode region 12, the second electrode region 14, the first electrode connecting region 16, the second electrode connecting region 20, the first lead-out electrode 22, and the second lead-out electrode 24 may be largely damaged. Also, too long wavelength is not preferable because efficient absorption and exothermic heating cannot be performed. Accordingly, the wavelength range is preferably the range from the ultraviolet to infrared among the above-mentioned wavelengths, and more preferably, in the range from 100 to 2000 nm.

One irradiation period (on) of the pulsed light is preferably from 20 microseconds to 50 milliseconds, although the period may vary depending on the light intensity. If the period is less than 20 microseconds, sintering of the metal nanowires or the metal fine particles does not progress, resulting in providing a lower effect of increasing the performance of a conductive film. If the period is longer than 50 milliseconds, there may be bad influences on the substrate 10, etc., due to photodegradation and thermal degradation, and further, nanowires or metal fine particles may be easily blown away. More preferably, the irradiation period is from 40 microseconds to 10 milliseconds. Due to the reasons mentioned above, pulsed light instead of continuous light is used in the present embodiment. A single shot of the pulsed light is effective, but the irradiation may be repeated as mentioned above. When the irradiation is repeated, the irradiation interval (off) is preferably in a range from 20 microseconds to 5 seconds, and more preferably in a range from 2000 microseconds to 2 seconds. If the irradiation interval is shorter than 20 microseconds, the pulsed light becomes similar to a continuous light and another irradiation is performed after one irradiation without leaving enough time for cooling. Thus, the substrate 10, etc., is heated to a very high temperature and is deteriorated. The irradiation interval longer than 5 seconds is not preferable because the processing time becomes long.

### (Second Aspect of Disclosure)

FIG. 8 to FIG. 11 show plan views of an example of a transparent conductive substrate for explaining production steps of a transparent conductive substrate for an electrostatic capacitance touch panel according to the second aspect of the disclosure. In the drawings, same numeral is assigned to the same structural component. In FIG. 8, a first electrode pattern including a plurality of first electrode regions 12 and a plurality of first electrode connecting regions 16 electrically connecting the adjacent first electrode regions 12 in one direction, is printed on one main face of a substrate 10 by a printing method such as inkjet printing, screen printing, gravure printing, flexo printing, and the like (First Electrode Pattern Printing Step). The transparent conductive ink used herein is the same as the ink used in the first aspect of the disclosure.

After being printed on one main face of the substrate 10, the first electrode pattern including the first electrode regions 12 and the first electrode connecting regions 16 is subjected to heating with an oven, heating by photo irradiation using a far-infrared lamp, and the like, to be dried and/or cured.

Thereafter, the first electrode pattern is subjected to pulsed light irradiation to sinter the metal nanowires or metal fine particles (First Electrode Pattern Sintering Step). Thereby, the first electrode pattern is provided with conductivity.

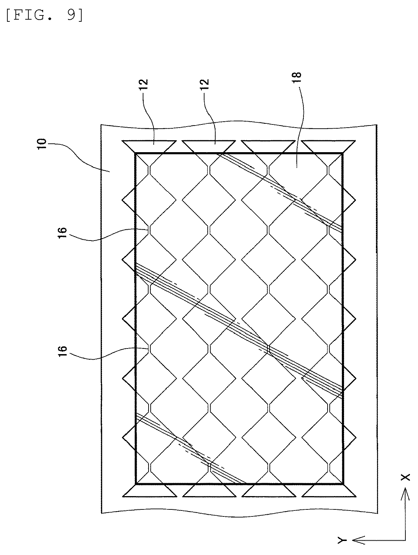

Next, as shown in FIG. 9, a transparent insulation layer 18 is formed on the first electrode pattern, the transparent insulation layer 18 covering the all of the first electrode connecting regions 16 and having a smaller area than the area where the first electrode pattern is formed (Transparent Insulation Layer Forming Step).

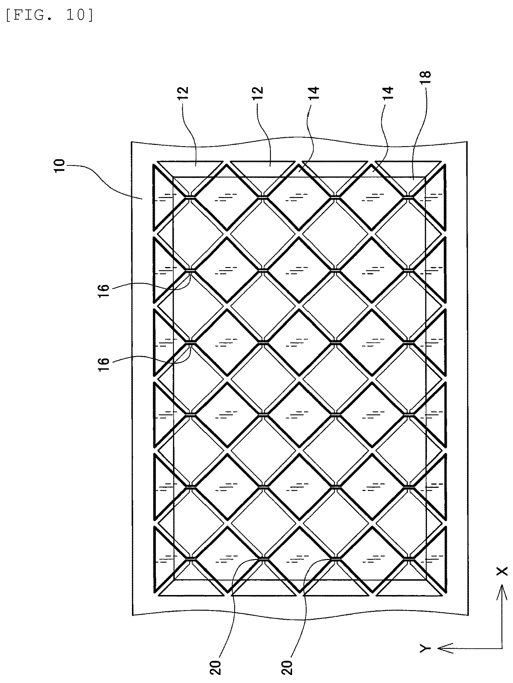

Then, as shown in FIG. 10, after the transparent insulation layer 18 is formed, a second electrode pattern is printed on the transparent insulation layer 18 with the transparent conductive ink, the second electrode pattern including a plurality of second electrode regions 14 located at positions different from the plurality of first electrode regions 12 on the plane of projection, and second electrode connecting regions 20 electrically connecting the adjacent second electrode regions 14 in the direction different from the connecting direction of the first electrode connecting regions 16 (Second Electrode Pattern Printing Step).

In the example of FIG. 10, the first electrode regions 12 and the first electrode connecting regions 16 are insulated from the second electrode regions 14 and the second electrode connecting regions 20, by the transparent insulation layer 18 having an area smaller than the area of the first electrode pattern. Except for this point, the present example is the same as the first aspect, in terms of the shapes of the first electrode region 12 and the second electrode region 14, and the angle (for example, perpendicular) between the first electrode connecting region 16 and the second electrode connecting region 20. The area of the transparent insulation layer is made smaller the area of the first electrode pattern in order to connect the lead-out electrode which is to be printed thereafter, to at least one end of the first electrode region 12.

The second electrode pattern including the second electrode regions 14 and the second electrode connecting regions 20 is printed on one main face of the substrate 10, and then, is subjected to heating with an oven, heating by photo irradiation using a far-infrared lamp, and the like, to be dried and/or cured.

Thereafter, the second electrode pattern is subjected to pulsed light irradiation to sinter the metal nanowires or metal fine particles (Second Electrode Pattern Sintering Step). Thereby, the second electrode pattern is provided with conductivity.

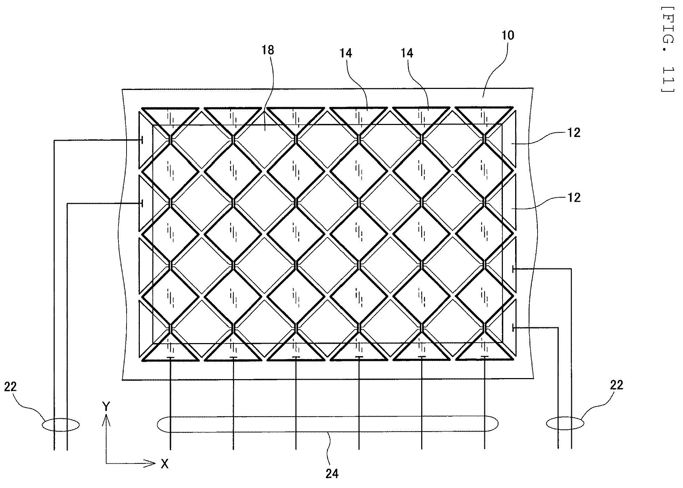

After the second electrode pattern sintering step, the first lead-out electrode 22 to be electrically connected to the first electrode region 12 located at the end of an array, and the second lead-out electrode 24 to be electrically connected to the second electrode region 14 located at the end of an array, are printed with the transparent conductive ink having metal fine particles as a metal component (Lead-Out Electrode Printing Step). The printed first lead-out electrode 22 and the second lead-out electrode 24 are subjected to heating with an oven, heating by photo irradiation using a far-infrared lamp, and the like, to be dried and/or cured. Thereafter, the first lead-out electrode 22 and the second lead-out electrode 24 are subjected to pulsed light irradiation to sinter the metal fine particles (Lead-Out Electrode Sintering Step). Thereby, as shown in FIG. 11, a transparent conductive substrate in which the first lead-out electrode 22 and the second lead-out electrode 24 are respectively connected to one electrode region located at the end of the array of first electrode regions 12 and one electrode region located at the end of the array of second electrode regions 14, may be produced.

When the first and second electrode regions 12 and 14 are formed with a transparent conductive ink containing metal fine particles as a metal component; in the above first electrode pattern printing step, the first lead-out electrode 22 to be electrically connected to the first electrode region 12 located at the end of the array may also be printed at the same time by the transparent conductive ink, and dried and/or cured; in the above first electrode pattern sintering step, the first lead-out electrode 22 may also be subjected to the pulsed light irradiation to sinter the metal fine particles; in the above second electrode pattern printing step, the second lead-out electrode 24 to be electrically connected to the second electrode region 14 located at the end of the array may also be printed at the same time, by the transparent conductive ink by the transparent conductive ink, and dried and/or cured; and in the above second electrode pattern sintering step, the dried second lead-out electrode 24 may also be subjected to the pulsed light irradiation to sinter the metal fine particles. Accordingly, as shown in FIG. 11, a transparent conductive substrate in which the first lead-out electrode 22 and the second lead-out electrode 24 are respectively connected to one electrode region located at the end of the array of first electrode regions 12 and one electrode region located at the end of the array of second electrode regions 14, may be produced.

When the transparent conductive ink containing metal fine particles as a metal component is used for forming the electrode regions, similar to the first aspect of the disclosure, the first electrode regions 12, the second electrode regions 14, the first electrode connecting regions 16, and the second electrode connecting regions 20 may be structured into a mesh form by a thin line lattice. Thereby, the portion where the first electrode regions 12, the second electrode regions 14, the first electrode connecting regions 16, the second electrode connecting regions 20, the first lead-out electrode 22, and the second lead-out electrode 24 are formed has an increased light transmittance, and the portion can maintain the transparency.

### Explanation on Numerals

10 substrate, 12 first electrode region, 14 second electrode region, 16 first electrode connecting region, 18 transparent insulation layer 20 second electrode connecting region, 22 first lead-out electrode, 24 second lead-out electrode, 26 overcoat layer

## Claims

1. A method for producing a transparent conductive substrate comprising a substrate provided on one main face thereof with a first electrode pattern comprising a plurality of first electrode regions, the adjacent first electrode regions being electrically connected with each other, and a second electrode pattern comprising a plurality of second electrode regions, the adjacent second electrode regions being electrically connected with each other, and the first electrode pattern being electrically separated from the second electrode pattern,
the method comprising a step of printing the first and second electrode regions into a predetermined pattern shape, with a transparent conductive ink containing metal nanowires or metal fine particles, and
a step for sintering the metal nanowires or the metal fine particles contained in the transparent conductive ink, by subjecting the first and second electrode region printed in the predetermined pattern shape to pulsed light irradiation.

2. A method for producing a transparent conductive substrate comprising:
an electrode region printing step for printing a plurality of first electrode regions and a plurality of second electrode regions with a transparent conductive ink containing metal nanowires or metal fine particles, on the same plane, at different positions,
a first electrode connecting region printing step for printing a first electrode connecting region which electrically connects adjacent first electrode regions with the transparent conductive ink in one direction,
a first sintering step for sintering the metal nanowires or metal fine particles by subjecting the first electrode regions, the second electrode regions and the first electrode connecting region to pulsed light irradiation,
a first electrode connecting region covering step for covering a surface of the first electrode connecting region with a transparent insulation layer, after the first sintering step,
a second electrode connecting region printing step for printing a second electrode connecting region which passes on the surface of the transparent insulation layer and electrically connects adjacent second electrode regions in a direction different from the connecting direction of the first electrode connecting region, with the transparent conductive ink, and
a second sintering step for sintering the metal nanowires or metal fine particles by subjecting the second electrode connecting region to pulsed light irradiation.

3. A method for producing a transparent conductive substrate according to claim 2, wherein the first electrode connecting region is formed to be perpendicular to the second electrode connecting region.

4. A method for producing a transparent conductive substrate according to claim 2 or claim 3 further comprising, after the second sintering step,
a lead-out electrode printing step for printing first lead-out electrode to be electrically connected to the first electrode region, and a second lead-out electrode to be electrically connected to the second electrode region, with the transparent conductive ink containing metal fine particles as a metal component, and
a lead-out electrode sintering step for sintering the metal fine particles by subjecting the first lead-out electrode and the second lead-out electrode to pulsed light irradiation.

5. A method for producing a transparent conductive substrate according to claim 2 or claim 3, wherein
the transparent conductive ink is a transparent conductive ink containing metal fine particles as a metal component,
in the electrode region printing step, the transparent conductive ink is used for forming the first electrode regions and the second electrode regions in a mesh form by lattices of thin lines, and for printing the first lead-out electrode to be electrically connected to the first electrode region, and the second lead-out electrode to be electrically connected to the second electrode region, and
in the first sintering step, the first lead-out electrode and the second lead-out electrode are also subjected to the pulsed light irradiation to sinter the metal fine particles.

6. A method for producing a transparent conductive substrate according to any one of claims 2 to 5, further comprising, forming an overcoat layer on the substrate already provided thereon with the first electrode regions, the second electrode regions, the first electrode connecting regions, the transparent insulation layers, the second electrode connecting regions, the first lead-out electrode, and the second lead-out electrode.

7. A method for producing a transparent conductive substrate comprising:
first electrode pattern printing step for printing a first electrode pattern with a transparent conductive ink containing metal nanowires or metal fine particles, the first electrode pattern comprising a plurality of first electrode region, and a first electrode region which electrically connects the adjacent first electrode regions in one direction,
a first electrode pattern sintering step for sintering the metal nanowires or the metal fine particles by subjecting the first electrode pattern to pulsed light irradiation,
a transparent insulation layer forming step for forming a transparent insulation layer on the first electrode pattern, the transparent insulation layer covering the entirety of the first electrode connecting regions and having an area smaller than the part where the first electrode pattern is formed,
a second electrode pattern printing step for printing a second electrode pattern on the transparent insulation layer, with the transparent conductive ink, the second electrode pattern comprising a plurality of second electrode regions located at positions different from the plurality of first electrode regions on the plane of projection, and second electrode connecting regions electrically connecting the adjacent second electrode regions in the direction different from the connecting direction of the first electrode connecting regions, and
a second electrode pattern sintering step for sintering the metal nanowires or the metal fine particles by subjecting the second electrode pattern to pulsed light irradiation.

8. A method for producing a transparent conductive substrate according to claim 7, wherein the first electrode connecting region is formed to be perpendicular to the second electrode connecting region.

9. A method for producing a transparent conductive substrate according to claim 7 or claim 8, further comprising, after the second electrode pattern sintering step,
a lead-out electrode printing step for printing first lead-out electrode to be electrically connected to the first electrode region, and a second lead-out electrode to be electrically connected to the second electrode region, with the transparent conductive ink containing metal fine particles as a metal component, and
a lead-out electrode sintering step for sintering the metal fine particles by subjecting the first lead-out electrode and the second lead-out electrode to pulsed light irradiation.

10. A method for producing a transparent conductive substrate according to claim 7 or claim 8, wherein
the transparent conductive ink is a transparent conductive ink containing metal fine particles as a metal component,
in the first electrode pattern printing step, the transparent conductive ink is used for forming the first electrode regions in a mesh form by lattices of thin lines, and for printing the first lead-out electrode to be electrically connected to the first electrode region,
in the first sintering step, the first lead-out electrode is also subjected to the pulsed light irradiation,
in the second electrode pattern printing step, the transparent conductive ink is used for forming the second electrode regions in a mesh form by lattices of thin lines, and for printing the second lead-out electrode to be electrically connected to the second electrode region, and
in the second sintering step, the second lead-out electrode is also subjected to the pulsed light irradiation.

11. A method for producing a transparent conductive substrate according to any one of claims 7 to 10, further comprising, forming an overcoat layer on the substrate already provided thereon with the first electrode regions, the first electrode connecting regions, the transparent insulation layer, the second electrode regions, the second electrode connecting regions, the first lead-out electrode, and the second lead-out electrode.

12. A transparent conductive substrate comprising a substrate provided on one main face thereof with,
a first electrode pattern comprising first electrode regions and a first electrode connecting region electrically connecting the first electrode regions, and formed by sintered metal, and
a second electrode pattern comprising second electrode regions and a second electrode connecting region electrically connecting the second electrode regions, and formed by sintered metal,
the first electrode regions and the second electrode regions being arranged on different positions on the same plane, and
the first electrode connecting region and the second electrode connecting region being nonparallel and spatially separated from each other.

13. A transparent conductive substrate according to claim 12, wherein the surface of the first electrode connecting region is covered with a transparent insulation layer having substantially the same shape as the first electrode connecting region, and the second electrode connecting region passes on the surface of the transparent insulation layer.

14. A transparent conductive substrate comprising a substrate provided on one main face thereof with,
a first electrode pattern comprising first electrode regions and a first electrode connecting region electrically connecting the first electrode regions, and formed by sintered metal,
a second electrode pattern comprising second electrode regions located at positions different from the first electrode regions on the plane of projection, and a second electrode connecting region electrically connecting the second electrode regions, and formed by sintered metal, and
a transparent insulation layer located between the first electrode pattern and the second electrode pattern, the transparent insulation layer covering the entirety of the first electrode connecting regions and having an area smaller than the part where the first electrode pattern is formed,
first electrode pattern and the second electrode pattern being arranged in directions intersecting with each other.
